# EUROPÄISCHE PATENTANMELDUNG

(11) **EP 0 810 641 A2**
(43) Veröffentlichungstag der Anmeldung: **03.12.1997**
(21) Anmeldenummer: 97108322.5
(22) Anmeldetag: 22.05.1997
(51) Int. Cl.: H01L 21/306, H01L 21/00

(54) **Verfahren zum Ätzen von Zerstörungszonen an einem Halbleitersubstratrand sowie Ätzanlage**

(30) Priorität: 31.05.1996 DE 19622015
(71) Anmelder: SIEMENS AKTIENGESELLSCHAFT, 80333 München (DE)
(72) Erfinder: Mathuni, Josef, Dr., 81737 München (DE)

(57) **Zusammenfassung**

Die vorliegende Erfindung gibt eine Vorrichtung und ein Verfahren an, mit dem auch ohne Belackung von Halbleitersubstratvorderseite 12 und Halbleitersubstratrückseite 13 der Halbleitersubstratrand 14 geätzt werden kann. Dabei wird das Halbleitersubstrat 11 in einer evakuierbaren Prozeßkammer 2 angeordnete Schutzkammer 3 eingebracht. Die Halbleitersubstratvorderseite 12 und die Halbleitersubstratrückseite 13 werden von dieser Schutzkammer 3 bis auf den zu ätzenden Halbleitersubstratrand 14 überdeckt. Auf den Halbleitersubstratrand 14 wird dann ein Ätzagens aufgebracht und die Ätzprodukte und überschüssiges Ätzagens werden abgeführt.

## Beschreibung

Die Erfindung betrifft ein Verfahren zum Ätzen von Zerstörungszonen an einem Halbleitersubstratrand eines Halbleitersubstrates mit belackungsfreier Halbleitersubstratvorderseite und belackungsfreier Halbleitersubstratrückseite sowie eine dazu geeignete Ätzanlage.

Bei der Herstellung von Siliziumscheiben werden die Scheibenränder geschliffen, um diese in eine geeignete Form zu bringen. Durch diese Schleifprozesse werden Störungen im Kristall erzeugt, die sich bei den folgenden Bearbeitungsprozessen vom Rand weg zu späteren Aktivbereichen hin ausbreiten können. Dort kommt es im allgemeinen zu einer Schädigung bzw. zu einem Ausfall des entsprechenden Bauelementes.

Zur Zeit werden zur Beseitigung dieser Schäden im wesentlichen zwei Verfahren angewandt. Zum einen werden die Scheibenränder mechanisch nachpoliert, womit aber nicht die tiefer liegenden Störstellen beseitigt werden können. Zum anderen erfolgt eine naßchemische Überätzung, sogenanntes chemisches Polieren, wobei die Halbleitersubstratvorderseite und Halbleitersubstratrückseite nicht mit abgetragen werden dürfen, da dies zu einer Verschlechterung der Dickenhomogenität der Scheibe führen würde. Daher werden die Halbleitersubstratvorderseiten und Halbleitersubstratrückseiten entsprechend geschützt, insbesondere werden sie mit Lack beschichtet. Diese Lackbeschichtungen stellen einen hohen Chemikalienverbrauch dar.

Aufgabe der vorliegenden Erfindung ist es daher, das eingangs genannte Verfahren dahingehend weiterzuentwickeln, daß eine Ätzung von Zerstörungszonen auch ohne großen Chemikalienverbrauch ermöglicht wird.

Erfindungsgemäß wird die Aufgabe durch ein Verfahren zum Ätzen von Zerstörungszonen an einem Halbleitersubstratrand eines Halbleitersubstrates mit folgenden Schritten gelöst:
a) das Halbleitersubstrat wird in eine in einer Prozeßkammer angeordneten Schutzkammer eingebracht, die die Halbleitersubstratvorderseite und die Halbleitersubstratrückseite bis auf den zu ätzenden Halbleitersubstratrand überdeckt,
b) auf den Halbleitersubstratrand wird ein Ätzagens aufgebracht und Ätzprodukte und überschüssiges Ätzagens werden abgeführt.

Durch die Einführung dieses vollständig belackungsfreien Verfahrens zum Ätzen von Zerstörungszonen ("Damage-Schichten") können Halbleitersubstratränder ökonomisch und sehr schnell geätzt werden.

Vorzugsweise wird bei dem erfindungsgemäßen Verfahren auf die Halbleitersubstratvorderseite und die Halbleitersubstratrückseite ein Schutzgas geleitet. Durch die Einleitung dieses Schutzgases wird gewährleistet, daß die Halbleitersubstratvorderseite und die Halbleitersubstratrückseite besonders gut vor einem Ätzangriff durch das Ätzagens geschützt werden. In der Regel langt aber ein geringer Überdruck innerhalb der Schutzkammer aus, der das Eindringen von Ätzagens dort weitgehend verhindert.

In einer bevorzugten Ausfuhrung wird als Ätzagens ein Gas oder eine Gasmischung verwendet. Dieses Gas oder diese Gasmischung werden dann vorzugsweise über Mikrowellen oder über Hochfrequenz zu einem Plasma in einer von der Prozeßkammer getrennten Plasmaerzeugungskammer angeregt, so daß der Ätzprozeß über Radikale ausgeführt wird. Dieses Verfahren läuft in bekannter Weise unter Vakuumbedingungen ab.

In einer alternativen Ausführungsform wird als Ätzagens eine Ätzlösung verwendet. Diese Ätzlösung wird in feinen Tröpfchen auf den zu ätzenden Halbleitersubstratrand gesprüht. Vorzugsweise wird dabei das Halbleitersubstrat und/oder die Prozeßkammer auf eine Temperatur von ≤ 100°C erwärmt, um ein besonders gutes chemisches Reagieren zwischen dem Halbleitersubstratrand und der Ätzlösung zu gewährleisten. Ferner bildet sich dadurch keine kondensierte Ätzlösung auf dem Halbleitersubstrat und der Prozeßkammer. Die Erwärmung kann über eine Heizvorrichtung oder über den Wärmeübertrag des Schutzgases erfolgen.

Die erfindungsgemäße Anlage zum Ätzen von Zerstörungszonen an einem Halbleitersubstratrand eines Halbleitersubstrates mit belackungsfreier Halbleitersubstratvorderseite und belackungsfreier Halbleitersubstratrückseite besteht aus:
α) einer Prozeßkammer,
β) einer in der Prozeßkammer angeordneten Schutzkammer, die die Halbleitersubstratvorderseite mit einem ersten Schutzkammerteil und die Halbleitersubstratrückseite mit einem zweiten Schutzkammerteil bis auf den zu ätzenden Halbleitersubstratrand überdeckt, sowie
γ) einem an der Prozeßkammer angeordneten Ätzagenseinlaß, durch den ein Ätzagens auf den Halbleitersubstratrand gebracht wird.

In einer bevorzugten Ausführung sind im Bereich des ersten Schutzkammerteils und im Bereich des zweiten Schutzkammerteils jeweils ein Schutzgaseinlaß angeordnet, durch den Schutzgas auf die belackungsfreie Halbleitersubstratvorderseite und die belackungsfreie Halbleitersubstratrückseite eingeleitet wird, um diese vor einem Ätzangriff wirksam zu schützen.

Ferner können im Bereich des ersten Schuztkammerteils eine Kopfplatte und im Bereich des zweiten Schutzkammerteils eine Fußplatte mit jeweils zumindest einer Öffnung, die zentral über der Halbleitersubstratvorderseite und zentral über der Halbleitersubstratrückseite angeordnet sind, vorgesehen sein, durch die das Schutzgas eingeströmt wird.

Ferner können die Kopfplatte und die Fußplatte an ihren Außenrändern mit Blenden versehen sein, die in Richtung des Halbleitersubstrates weisen. Zusätzlich sind dann in der Prozeßkammer oder an den Schutzkammerteilen um diese Blenden Außenblenden vorgesehen, die den zu ätzenden Halbleitersubstratrand definieren, wobei zwischen den Blenden und den Außenblenden Spalte vorgesehen sind, über die das eingeleitete Schutzgas über die Evakuiervorrichtung abgesaugt wird.

Zur Halterung des Halbleitersubstrates kann im Bereich des zweiten Schutzkammerteils zumindest drei Stifte vorgesehen sein.

In einer besonders bevorzugten Ausführungsform können anstatt der drei Stifte in der Prozeßkammer eine Halteblende vorgesehen sein, auf der das Halbleitersubstrat nur über seine Halbleitersubstrataußenkante aufliegt. Durch diese Maßnahme wird gewährleistet, daß das Halbleitersubstrat weder auf seiner Halbleitersubstratvorderseite noch auf seiner Halbleitersubstratrückseite berührt wird und dadurch vor Beschädigungen geschützt ist.

Vorzugsweise ist die Ätzanlage nach der vorliegenden Erfindung in eine sogenannte Mehrkammeranlage integriert, so daß Einbringen und Herausnehmen des zu ätzenden Halbleitersubstrates vollautomatisch erfolgt, und noch andere weitere bzw. vorhergehende Prozeßschritte innerhalb dieser Mehrkammeranlage unmittelbar stattfinden können.

Die Erfindung ist in der Zeichnung beispielsweise veranschaulicht und im Nachstehenden im einzelnen anhand der Zeichnung beschrieben. Es zeigen:
- Figur 1: in schematischer Darstellung eine Ansicht der Vorrichtung und
- Figur 2: eine vergrößerte Teilansicht des Bereiches I aus Figur 1.

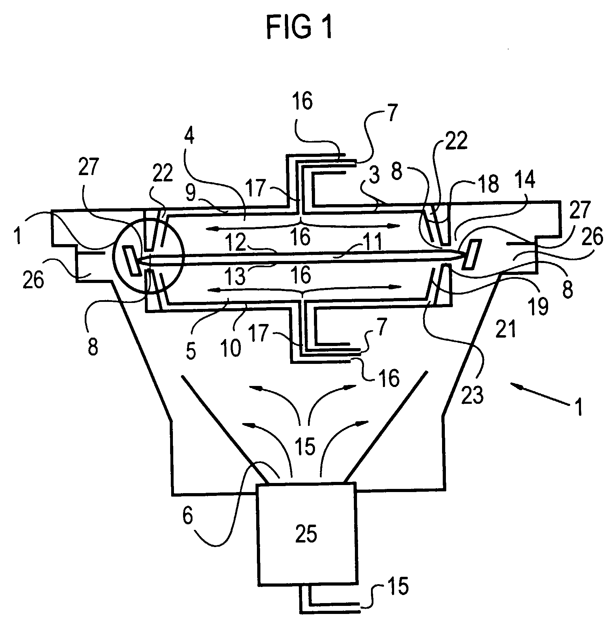

Wie aus der Figur 1 ersichtlich ist, besteht die erfindungsgemäße Anlage 1 zum Ätzen hier aus einer Evakuiervorrichtung (nicht gezeigt), die mit einer Prozeßkammer 2 verbunden ist.

In der Prozeßkammer 2 ist eine Schutzkammer 3 angeordnet. In die Schutzkammer 3 ist ein scheibenförmiges Halbleitersubstrat 11 (Siliziumwafer) mit einer belackungsfreien Halbleitersubstratrückseite 13 und einer belackungsfreien Halbleitersubstratvorderseite 12 eingebracht. Im vorliegenden Ausführungsbeispiel weist die belackungsfreie Halbleitersubstratvorderseite 12 mit ihrem Gesicht nach oben, d. h. sie ist in ihrer natürlichen Lage in die Schutzkammer 3 eingebracht worden.

Die Schutzkammer 3 besteht aus einem ersten in der Prozeßkammer 2 oben angeordneten Schutzkammerteil 4 und einem zweiten in der Prozeßkammer 2 unten angeordneten Schutzkammerteil 5. Der erste Schutzkammerteil 4 überdeckt dabei die Halbleitersubstratvorderseite 12 und der zweite Schutzkammerteil 5 überdeckt die Halbleitersubstratrückseite 13, wobei der zu ätzende Halbleitersubstratrand 14 nicht überdeckt wird.

In dem ersten Schutzkammerteil 4 und in dem zweiten Schutzkammerteil 5 ist jeweils ein Schutzgaseinlaß 7 angeordnet. Durch diese Schutzgaseinlaße wird ein Schutzgas 16 auf die belackungsfreie Halbleitersubstratvorderseite 12 bzw. auf die belackungsfreie Halbleitersubstratrückseite 13 zum Schutz dieser vor einem Ätzangriff eingeleitet.

Im Bereich des ersten Schutzkammerteils 4 befindet sich eine Kopfplatte 9, die eine Öffnung 17 aufweist, die zentral über der Halbleitersubstratvorderseite 12 angeordnet ist und durch die das Schutzgas 16 auf die Halbleitersubstratvorderseite 12 strömt.

Im Bereich des zweiten Schutzkammerteils 5 befindet sich analog eine Fußplatte 10. Diese Fußplatte 10 weist ebenfalls eine Öffnung 17 auf, die zentral unter der Halbleitersubstratrückseite 13 angeordnet ist und durch die Schutzgas auf die Halbleitersubstratrückseite 13 strömt.

Sowohl die Kopfplatte 9 als auch die Fußplatte 10 weisen an ihren Außenrändern auf das Halbleitersubstrat 11 weisende Blenden 18, 19 auf. Ferner sind außerhalb dieser Blenden 18, 19 Außenblenden 20, 21 in der Prozeßkammer 2 angeordnet, die den zu ätzenden Halbleitersubstratrand 14 vorgeben.

Zwischen den Blenden 18, 19 und den Außenblenden 20, 21 sind Spalte 22, 23, die dazu dienen, das eingeleitete Schutzgas 16 über die Absaugvorrichtung abzusaugen.

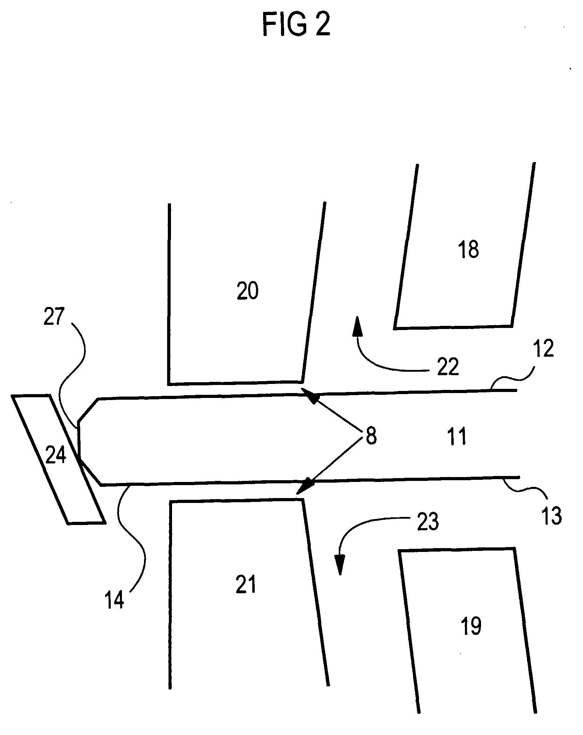

Wie insbesondere aus der Figur 2 zu sehen ist, wird das Halbleitersubstrat 11 im vorliegenden Ausführungsbeispiel über eine Haltevorrichtung 24, die hier aus mehreren in der Prozeßkammer angeordneten Stiften besteht, lediglich an seiner Halbleitersubstrataußenkante 27 gehalten. Zwischen den Außenblenden 20, 21 und der Halbleitersubstratvorderseite 12 einerseits und der Halbleitersubstratrückseite 13 andererseits sind Abstände 8 von ungefähr 0,1 mm, durch die das eingeströmte Schutzgas abgesaugt wird. Die Spalte 22, 23 zwischen der Blende 18 und der Außenblende 20 einerseits und der Blende 19 und der Außenblende 21 andererseits weisen typischerweise eine Breite von circa 2 mm auf. Durch diese Spalte 22, 23 wird zusätzlich das eingeströmte Schutzgas abgesaugt. Als Schutzgas wird in der Regel Stickstoff verwendet. Es können aber auch Argon bzw. andere Wertgase verwendet werden.

Ferner befindet sich in der Prozeßkammer 2 ein Ätzagenseinlaß 6, mit dem ein Ätzagens 15 in die Prozeßkammer 2 eingeleitet wird. Als Ätzagens 15 wird im vorliegenden Fall eine Gasmischung verwendet. Diese Gasmischung ist eine Mischung aus CF₄ und O₂, es sind jedoch auch andere Mischungen möglich.

Die eingeleitete Gasmischung wird hier über Mikrowellen in einer von der Prozeßkammer 2 getrennten Plasmaerzeugungskammer 25 zu einem Plasma angeregt.

Die dadurch erzeugten Radikale gelangen auf den zu ätzenden Halbleitersubstratrand 14 und reagieren dort mit dem Halbleitermaterial in den Zerstörungszonen. Die Ätzprodukte und die überschüssige Ätzgasmischung werden über die Absaugvorrichtung (nicht gezeigt) abgesaugt, mit der die Prozeßkammer 2 in der Höhe des Halbleitersubstratrandes 14 durch einen dort angeordneten ringförmigen Spalt 26 verbunden ist.

Die Außenblenden 20, 21 und die Blenden 18, 19 sind lateral in der Prozeßkammer 2 verschieblich angeordnet, so daß die Breite des zu ätzenden Halbleitersubstratrandes 14 einstellbar ist.

### Bezugszeichenliste:

- 1: Ätzanlage
- 2: Prozeßkammer
- 3: Schutzkammer
- 4: erstes Schutzkammerteil
- 5: zweites Schutzkammerteil
- 6: Ätzagenseinlaß
- 7: Schutzgaseinlaß
- 8: Abstände
- 9: Kopfplatte
- 10: Fußplatte
- 11: Halbleitersubstrat
- 12: Halbleitersubstratvorderseite
- 13: Halbleitersubstratrückseite
- 14: Halbleitersubstratrand
- 15: Ätzagens
- 16: Schutzgas
- 17: Öffnung
- 18: Blende
- 19: Blende
- 20: Außenblende
- 21: Außenblende
- 22: Spalt
- 23: Spalt
- 24: Haltevorrichtung
- 25: Plasmaerzeugungskammer
- 26: ringförmiger Spalt
- 27: Halbleitersubstrataußenkante

## Patentansprüche

1. Verfahren zum Ätzen von Zerstörungszonen auf einem Halbleitersubstratrand (14) eines Halbleitersubstrates (11) mit belackungsfreier Halbleitersubstratvorderseite (12) und belackungsfreier Halbleitersubstratrückseite (13) mit folgenden Schritten:
a) das Halbleitersubstrat (11) wird in eine in einer Prozeßkammer (2) angeordneten Schutzkammer (3) eingebracht, die die Halbleitersubstratvorderseite (12) und die Halbleitersubstratrückseite (13) bis auf den zu ätzenden Halbleitersubstratrand (14) überdeckt,
b) auf den Halbleitersubstratrand (14) wird ein Ätzagens aufgebracht und Ätzprodukte und überschüssiges Ätzagens werden abgeführt.

2. Verfahren nach Anspruch 1,
**dadurch gekennzeichnet,**
daß auf die Halbleitersubstratvorderseite (12) und die Halbleitersubstratrückseite (14) ein Schutzgas (16) geleitet wird.

3. Verfahren nach Anspruch 1 oder 2,
**dadurch gekennzeichnet,**
daß als Ätzagens (15) ein Gas oder eine Gasmischung verwendet wird.

4. Verfahren nach Anspruch 3,
**dadurch gekennzeichnet,**
daß das Gas oder die Gasmischung über Mikrowellen oder über Hochfrequenz zu einem Plasma angeregt werden und die Prozeßkammer (2) evakuiert wird.

5. Verfahren nach Anspruch 4,
**dadurch gekennzeichnet,**
daß das Plasma in einer von der Prozeßkammer (2) getrennten Plasmaerzeugungskammer (25) erzeugt wird.

6. Verfahren nach Anspruch 1 oder 2,
**dadurch gekennzeichnet,**
daß als Ätzagens (15) eine Ätzlösung verwendet wird und die Ätzlösung auf den Halbleitersubstratrand (14) gesprüht wird.

7. Verfahren nach Anspruch 6,
**dadurch gekennzeichnet,**
daß das Halbleitersubstrat (11) und/oder die Prozeßkammer (2) auf eine Temperatur von ≤ 100°C erwärmt wird.

8. Anlage zum Ätzen von Zerstörungszonen an einem Halbleitersubstratrand (14) eines Halbleitersubstrates (11) mit belackungsfreier Halbleitersubstratvorderseite (12) und belackungsfreier Halbleitersubstratrückseite (13) bestehend aus:
α) einer Prozeßkammer (2),
β) einer in der Prozeßkammer (2) angeordneten Schutzkammer (3), die die Halbleitersubstratvorderseite (12) mit einem ersten Schutzkammerteil (4) und die Halbleitersubstratrückseite (13) mit einem zweiten Schutzkammerteil (5) bis auf den zu ätzenden Halbleitersubstratrand (14) überdeckt, sowie
γ) einem an der Prozeßkammer (2) angeordneten Ätzagenseinlaß (6), durch den ein Ätzagens (15) auf den Halbleitersubstratrand (14) gebracht wird.

9. Ätzanlage nach Anspruch 8,
**dadurch gekennzeichnet,**
daß im Bereich des ersten Schutzkammerteils (4) und im Bereich des zweiten Schutzkammerteils (5) jeweils ein Schutzgaseinlaß (7) angeordnet ist, durch den Schutzgas (16) auf die belackungsfreie Halbleitersubstratvorderseite (12) und die belackungsfreie Halbleitersubstratrückseite (13) zum Schutz dieser vor einem Ätzangriff eingeleitet wird.

10. Ätzanlage nach Anspruch 9,
**dadurch gekennzeichnet,**
daß im Bereich des ersten Schutzkammerteils (4) eine Kopfplatte (9) und im Bereich des zweiten Schutzkammerteils (5) eine Fußplatte (10) mit jeweils zumindest einer Öffnung (17), die zentral über der Halbleitersubstratvorderseite (12) und zentral über der Halbleitersubstratrückseite (13) angeordnet sind, vorgesehen sind, durch die das Schutzgas (16) einströmt.

11. Ätzanlage nach Anspruch 10,
**dadurch gekennzeichnet,**
daß die Kopfplatte (9) und die Fußplatte (10) an ihren Außenrändern mit Blenden (18, 19) versehen sind und daß in der Prozeßkammer (2) oder an den Schutzkammerteilen (4, 5) um diese Blenden (18, 19) Außenblenden (20, 21) vorgesehen sind, die den zu ätzenden Halbleitersubstratrand (14) definieren, und daß zwischen den Blenden (18, 19) und den Außenblenden (20, 21) Spalte (22, 23) vorgesehen sind, über die das eingeleitete Schutzgas (16) abgeführt wird.

12. Ätzanlage nach einem der Ansprüche 8 bis 11,
**dadurch gekennzeichnet,**
daß im Bereich des zweiten Schutzkammerteils zumindest drei Stifte vorgesehen sind, auf dem das Halbleitersubstrat aufliegt.

13. Ätzanlage nach einem der Ansprüche 8 bis 11,
**dadurch gekennzeichnet,**
daß in der Prozeßkammer (2) eine Haltevorrichtung (24) vorgesehen ist, auf der das Halbleitersubstrat (11) nur punktuell über seine Halbleitersubstrataußenkante (27) aufliegt.

14. Ätzanlage nach einem der Ansprüche 8 bis 13,
**dadurch gekennzeichnet,**
daß die Ätzanlage Bestandteil einer Mehrkammeranlage ist.
